# EUROPEAN PATENT APPLICATION

(11) **EP 4 491 390 A1**
(43) Date of publication of application: **15.01.2025**
(21) Application number: 23795132.2
(22) Date of filing: 19.04.2023
(51) Int. Cl.: B32B 17/02, B32B 17/06, B32B 27/38, H04M 1/02

(54) **HOUSING ASSEMBLY, METHOD FOR MANUFACTURING HOUSING ASSEMBLY, AND ELECTRONIC APPARATUS**

(30) Priority: 29.04.2022 CN 202210467203
(71) Applicant: Huawei Technologies Co., Ltd., Shenzhen, Guangdong 518129 (CN)
(72) Inventor: YANG, Xutong, Shenzhen, Guangdong 518129 (CN); XING, Tianyi, Shenzhen, Guangdong 518129 (CN); XING, Chong, Shenzhen, Guangdong 518129 (CN)
(74) Representative: Thun, Clemens
(86) International application number: PCT/CN2023/089179
(87) International publication number: WO 2023/207699

(57) **Abstract**

A housing assembly, a housing assembly preparation method, and an electronic device are provided. The housing assembly includes: a substrate, where the substrate includes a first surface and a second surface that are opposite to each other, the first surface of the substrate is close to an electronic device, and the substrate is formed through hot-pressing after glass fiber cloth is soaked in an epoxy resin adhesive solution; a first decoration layer, disposed on the first surface of the substrate; a light shielding layer, disposed on a surface that is of the first decoration layer and that is away from the substrate; and a second decoration layer, disposed on the second surface of the substrate. Therefore, the substrate uses a glass fiber epoxy resin plate, which is a light and thin material, and is high in strength, modulus, and transparency. Decoration layers may be disposed on both surfaces, and a decoration effect is better.

## Description

This application claims priority to Chinese Patent Application No. 202210467203.6, filed with the China National Intellectual Property Administration on April 29, 2022 and entitled "HOUSING ASSEMBLY, HOUSING ASSEMBLY PREPARATION METHOD, AND ELECTRONIC DEVICE", which is incorporated herein by reference in its entirety.

### TECHNICAL FIELD

Embodiments of this application relate to the field of electronic device technologies, and in particular, to a housing assembly, a housing assembly preparation method, and an electronic device.

### BACKGROUND

With development of a mobile phone terminal and a plastic battery cover industry, it is a unified pursuit in the industry to build a light, high-strength, and high-design appearance battery cover.

Currently, elements of the battery cover include polycarbonate (Polycarbonate, PC), but the PC has a small modulus, low rigidity, and poor texture. The modulus is a ratio of a stress to a strain of a material in a stressed state.

In addition, in the conventional technology, a decoration layer is disposed only on one side of the battery cover, and consequently a decoration effect is poor.

### SUMMARY

Embodiments of this application provide a housing assembly, a housing assembly preparation method, and an electronic device. Decoration layers may be disposed on both sides of the housing assembly, and a decoration effect is better.

To achieve the foregoing objective, the following technical solutions are used in embodiments of this application.

According to a first aspect of embodiments of this application, a housing assembly is provided, including: a substrate, where the substrate includes a first surface and a second surface that are opposite to each other, the first surface of the substrate is close to an electronic device, and the substrate is formed through hot-pressing after glass fiber cloth is soaked in an epoxy resin adhesive solution; a first decoration layer, disposed on the first surface of the substrate; a light shielding layer, disposed on a surface that is of the first decoration layer and that is away from the substrate; and a second decoration layer, disposed on the second surface of the substrate. Therefore, the substrate uses a glass fiber epoxy resin plate, which is a light and thin material, and is high in strength, modulus, and transparency. Decoration layers may be disposed on both surfaces, and a decoration effect is better. The light shielding layer can prevent light from penetrating and prevent light leakage.

In an optional implementation, the first decoration layer includes a reflection layer and at least one of a color layer and a texture layer that are stacked, where the color layer and the texture layer are close to the substrate, and the reflection layer is away from the substrate. Therefore, the first decoration layer includes a plurality of layers, so that the layers are richer and a decoration effect is better. The color layer may enrich a color effect of the product, and the texture layer may enable a finally prepared product to reflect light differently, so that the product has special texture in appearance, and a product appearance use effect is enriched. The reflection layer is configured to reflect light transmitted by the second surface of the substrate, so that the color layer and the texture layer can reflect a good appearance decoration effect.

In an optional implementation, the housing assembly further includes a membrane, the first decoration layer is disposed on the membrane, and the membrane is bonded to the first surface of the substrate by using a transparent adhesive layer. Therefore, the membrane is bonded to the substrate by using the transparent adhesive layer, and a process is simple.

In an optional implementation, the housing assembly further includes a membrane, the membrane is located on the first surface of the substrate, the membrane and the substrate are integrally formed through hot-pressing, and the first decoration layer is disposed on the membrane. Therefore, the membrane and the substrate are directly formed through hot-pressing, and the connection is more stable.

In an optional implementation, the second decoration layer includes a hardening layer, and a surface of the hardening layer is a frosted surface. Therefore, a surface with a glitter sand effect may be formed, and a product appearance use effect may be further enriched.

In an optional implementation, a first glossy coating is disposed between the first surface of the substrate and the first decoration layer. Therefore, the first glossy coating can better attach the first decoration layer to the surface of the substrate.

In an optional implementation, a second glossy coating is disposed between the second surface of the substrate and the second decoration layer. Therefore, the second glossy coating can better attach the second decoration layer to the surface of the substrate.

According to a second aspect of embodiments of this application, a housing assembly preparation method is provided, including: soaking glass fiber cloth in an epoxy resin adhesive solution and then performing hot-pressing to form a substrate, where the substrate includes a first surface and a second surface that are disposed opposite to each other, and the first surface of the substrate is disposed close to an electronic device; forming a first decoration layer on the first surface of the substrate; forming a light shielding layer on a surface of the first decoration layer; and forming a second decoration layer on the second surface of the substrate. Therefore, the substrate uses a glass fiber epoxy resin plate, which is a light and thin material, and is high in strength, modulus, and transparency. Decoration layers may be disposed on both surfaces, and a decoration effect is better. The light shielding layer can prevent light from penetrating and prevent light leakage.

In an optional implementation, the forming a first decoration layer on the first surface of the substrate includes: sequentially stacking at least one of a color layer and a texture layer on the first surface of the substrate. Therefore, the first decoration layer includes a plurality of layers, so that the layers are richer and a decoration effect is better. The color layer may enrich a color effect of the product, and the texture layer may enable a finally prepared product to reflect light differently, so that the product has special texture in appearance, and a product appearance use effect is enriched.

In an optional implementation, after the sequentially stacking at least one of a color layer and a texture layer on the first surface of the substrate, the method further includes: electroplating a reflection layer on the color layer or the texture layer. Therefore, the reflection layer is configured to reflect light transmitted by the second surface of the substrate, so that the color layer and the texture layer can reflect a good appearance decoration effect.

In an optional implementation, a housing assembly further includes a membrane, and the forming a first decoration layer on the first surface of the substrate includes: forming the first decoration layer on a first surface of the membrane, where the membrane includes the first surface and a second surface that are opposite to each other; and bonding the membrane to the first surface of the substrate by using a transparent adhesive layer, where the second surface of the membrane is opposite to the first surface of the substrate. Therefore, the membrane is bonded to the substrate by using the transparent adhesive layer, no hot-pressing is required, and a process is simpler.

In an optional implementation, a housing assembly further includes a membrane, and the forming a first decoration layer on the first surface of the substrate includes: integrally forming the substrate and the membrane through hot-pressing; and forming the first decoration layer on a first surface of the membrane, where the membrane includes the first surface and a second surface that are opposite to each other. Therefore, the membrane and the substrate are directly formed through hot-pressing, and the connection is more stable.

In an optional implementation, the forming the first decoration layer on a first surface of the membrane includes: sequentially stacking at least one of a color layer and a texture layer on the first surface of the membrane. Therefore, the first decoration layer includes a plurality of layers, so that the layers are richer and a decoration effect is better.

In an optional implementation, after the sequentially stacking at least one of a color layer and a texture layer on the first surface of the membrane, the method further includes: electroplating a reflection layer on the color layer or the texture layer. Therefore, the reflection layer is configured to reflect light transmitted by the second surface of the substrate, so that the color layer and the texture layer can reflect a good appearance decoration effect.

In an optional implementation, the forming a second decoration layer on the second surface of the substrate includes: coating hardening liquid on the second surface of the substrate to form a hardening layer; performing mold rubbing on a surface of the semi-cured hardening layer to form a frosted surface; and curing the hardening layer. Therefore, a surface with a glitter sand effect may be formed, and a product appearance use effect may be further enriched.

In an optional implementation, before the forming a first decoration layer on the first surface of the substrate, the method further includes: printing a first glossy coating on the first surface of the substrate. Therefore, the first glossy coating can better attach the first decoration layer to the surface of the substrate.

In an optional implementation, before the forming a second decoration layer on the second surface of the substrate, the method further includes: printing a first glossy coating on the second surface of the substrate. Therefore, the second glossy coating can better attach the second decoration layer to the surface of the substrate.

According to a third aspect of embodiments of this application, an electronic device is provided, including a middle frame, a display, and a battery cover, where the battery cover and the display are respectively connected to two opposite sides of the middle frame, and the battery cover includes the housing assembly described above, or the battery cover includes the housing assembly obtained by using the foregoing preparation method. Therefore, the electronic device uses the foregoing housing assembly, and a decoration effect is better.

According to the housing assembly, the housing assembly preparation method, and the electronic device provided in this application, the substrate of the housing assembly is formed through hot-pressing after the glass fiber cloth is soaked in the epoxy resin adhesive solution, so that the substrate is high in transparency, and the decoration layers can be formed on the two surfaces of the substrate, thereby implementing an inner texture effect and an outer glitter sand effect. The substrate is used in the battery cover, and therefore the decoration effect is better, and the battery cover features a light and high-strength characteristic.

### BRIEF DESCRIPTION OF DRAWINGS

FIG. 1 is a diagram of a disassembled structure of an electronic device;
FIG. 2 is a diagram of a structure of a battery cover according to an embodiment of this appli cati on;
FIG. 3 is a diagram of a partial structure of a battery cover according to an embodiment of this application;
FIG. 4 is a sectional view of a housing assembly in FIG. 2 along A-A;
FIG. 5 is a diagram of a structure of a first decoration layer according to an embodiment of this application;
FIG. 6 is a diagram of a structure of another first decoration layer according to an embodiment of this application;
FIG. 7 is a diagram of a structure of still another first decoration layer according to an embodiment of this application;
FIG. 8 is a sectional view of another housing assembly in FIG. 2 along A-A;
FIG. 9 is a sectional view of still another housing assembly in FIG. 2 along A-A;
FIG. 10 is a flowchart of a housing assembly preparation method according to an example 1 of this application;
FIG. 11, FIG. 12, FIG. 13, and FIG. 14 are respectively diagrams of structures of products formed after steps in FIG. 10 are performed;
FIG. 15 is a flowchart of a method for preparing a first decoration layer according to an example 1;
FIG. 16, FIG. 17, and FIG. 18 are respectively diagrams of structures of products formed after steps in FIG. 15 are performed;
FIG. 19 is a flowchart of a method for preparing a second decoration layer according to an embodiment of this application;
FIG. 20 is a flowchart of a housing assembly preparation method according to an example 2 of this application;
FIG. 21 is a diagram of a structure of a product formed after S105 in FIG. 20 is performed;
FIG. 22 is a diagram of a structure of a product formed after S106 in FIG. 20 is performed;
FIG. 23 is a flowchart of a method for preparing a first decoration layer according to an example 2;
FIG. 24, FIG. 25, and FIG. 26 are respectively diagrams of structures of products formed after steps in FIG. 23 are performed;
FIG. 27 is a flowchart of a housing assembly preparation method according to an example 3 of this application;
FIG. 28 is a diagram of a structure of a product formed after S107 in FIG. 27 is performed;
FIG. 29 is a diagram of a structure of a product formed after S108 in FIG. 27 is performed;
FIG. 30 is a flowchart of a housing assembly preparation method according to an example 4; and
FIG. 31 is a flowchart of a housing assembly preparation method according to an example 5.

### DESCRIPTION OF EMBODIMENTS

To make the objectives, technical solutions, and advantages of this application clearer, the following further describes this application in detail with reference to the accompanying drawings.

The terms "first" and "second" mentioned below are merely intended for a purpose of description, and shall not be understood as an indication or implication of relative importance or implicit indication of a quantity of indicated technical features. Therefore, features defined with "first", "second", and the like may explicitly or implicitly include one or more such features. In description of this application, unless otherwise stated, "a plurality of" means two or more than two.

In addition, in this application, position terms such as "up", and "down" are defined relative to an illustrative position of a component in the accompanying drawings. It should be understood that these direction terms are relative concepts and are used for relative description and clarification, and may vary accordingly depending on a position change in which components are placed in the accompanying drawings.

Embodiments of this application provide an electronic device. The electronic device may be a product having a display interface, such as a tablet computer, a mobile phone, an electronic reader, a remote control, a personal computer (personal computer, PC), a notebook computer, a personal digital assistant (personal digital assistant, PDA), a vehicle-mounted device, a web television, a wearable device, or a television, or a smart display wearable product such as a smart watch or a smart band. A specific form of the electronic device is not specially limited in embodiments of this application. For ease of description, an example in which the electronic device is a mobile phone is used for description in the following embodiments.

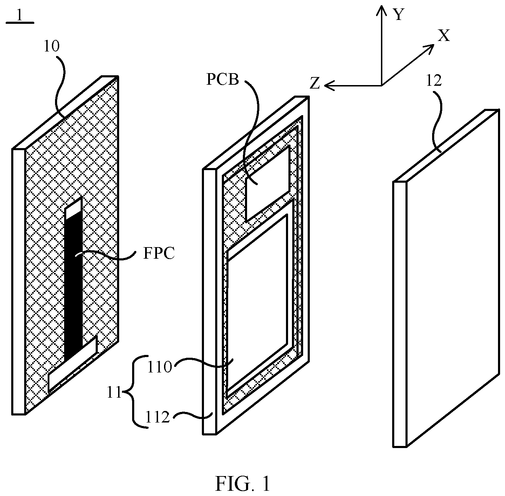

As shown in FIG. 1, an electronic device 1 includes a display assembly 10, a middle frame 11, and a battery cover (or referred to as a rear housing) 12. The middle frame 11 is located between the display assembly 10 and the battery cover 12.

The display assembly 10 is configured to display an image.

The display assembly 10, the middle frame 11, and the battery cover 12 may be disposed at different layers in a thickness direction of the electronic device. These layers may be parallel to each other. A plane in which each layer is located may be referred to as an X-Y plane, and a direction perpendicular to the X-Y plane may be referred to as a Z direction. In other words, the display assembly 10, the middle frame 11, and the battery cover 12 may be distributed in layers in the Z direction.

After passing through the middle frame 11 by using a flexible printed circuit (flexible printed circuit, FPC) board shown in FIG. 1, the display assembly 10 may be electrically connected to a PCB disposed on the middle frame 11. Therefore, the PCB can transmit display data to the display assembly 10, to control the display assembly 10 to display an image.

The middle frame 11 is located between the display assembly 10 and the battery cover 12. A surface that is of the middle frame 11 and that is away from the display assembly 10 is used to install internal components like a battery, a printed circuit board (printed circuit board, PCB), a camera (camera), and an antenna. After the battery cover 12 is closed with the middle frame 11, the foregoing internal components are located between the battery cover 12 and the middle frame 11.

The battery cover 12 is connected to the middle frame 11 to form an accommodating cavity used to accommodate the electronic components like the PCB, the camera, and the battery. Therefore, moisture and dust from the outside can be prevented from entering the accommodating cavity and affecting performance of the electronic components.

An existing battery cover uses a PC plate, but the PC plate has a small modulus, low rigidity, and poor texture. In addition, a decoration layer is disposed only on a single side, and consequently a decoration effect is poor.

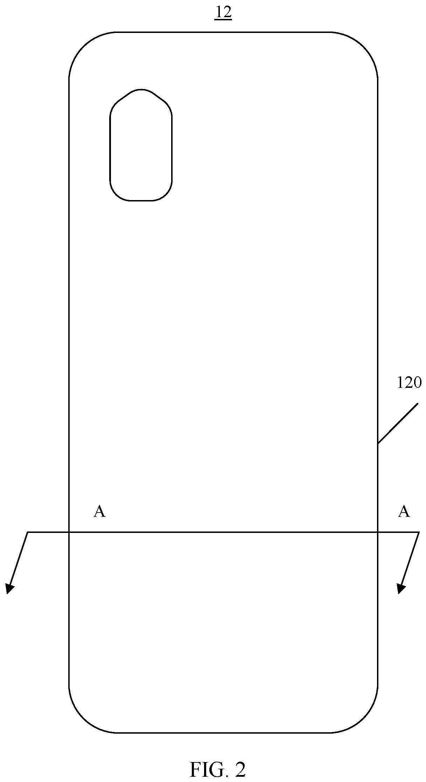

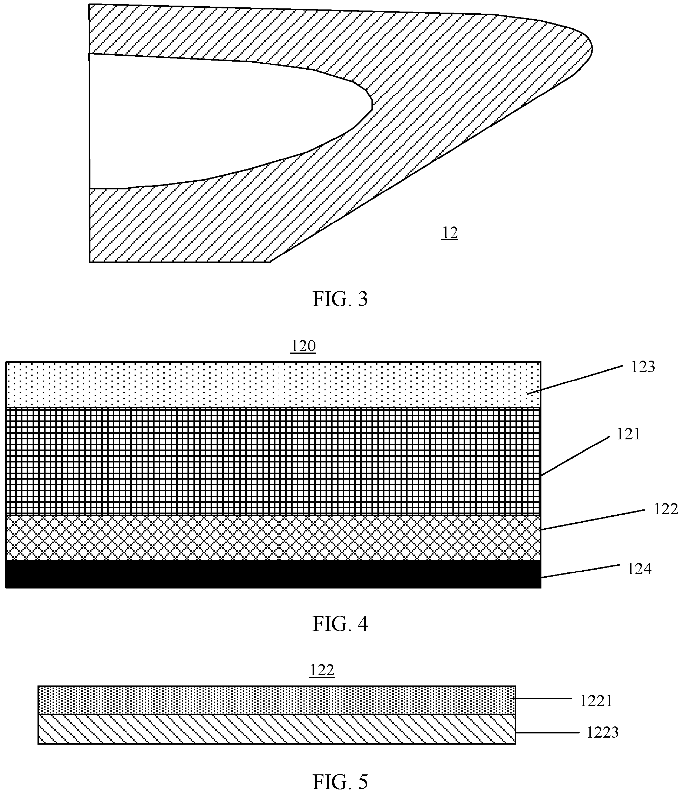

Embodiments of this application provide an improved battery cover. As shown in FIG. 2 and FIG. 3, the battery cover 12 includes a housing assembly 120. The battery cover may be obtained by processing the housing assembly 120 through computer numerical control (Computer Numerical Control, CNC).

For example, a thickness of the battery cover is 0.35 mm to 0.65 mm.

CNC processing may mill off surplus materials of edges and corners of the housing assembly 120, to obtain a battery cover in a finally required size suitable for assembling.

For example, R angle modification may be performed on the housing assembly 120 through CNC, to obtain a battery cover in a required form. An R angle of the battery cover 12 is shown in FIG. 2.

It should be noted that the R angle is a rounded corner of an arc tangent to two intersecting straight lines. The R angle modification means cutting and polishing a right angle of the battery cover to make the right angle into a rounded corner.

FIG. 4 is a sectional view along A-A in FIG. 2. As shown in FIG. 4, the housing assembly includes a first decoration layer 122, a substrate 121, and a second decoration layer 123 that are stacked.

The substrate 121 includes a first surface and a second surface that are opposite to each other. The first surface of the substrate 121 is close to the display assembly. The substrate 121 includes a glass fiber epoxy resin composite plate, and may be formed through hot-pressing after glass fiber cloth is soaked in an epoxy resin adhesive solution.

The glass fiber epoxy resin composite plate is high in strength and modulus. The glass fiber epoxy resin composite plate is used for the battery cover, which is a light and thin material, and is high in strength.

A thickness, a quantity of layers, and a combination form of the glass fiber cloth are not limited in embodiments of this application. For example, a thickness of single-layer glass fiber cloth may be 0.03 mm to 0.2 mm, a thickness of each stacked layer and a quantity of stacked layers are not limited, and a thickness of a high-transparency glass fiber plate formed through stacking and hot-pressing is 0.3 mm to 0.6 mm.

Preferably, the thickness of the glass fiber cloth is 0.05 mm or 0.1 mm.

A quantity of layers of stacked glass fiber cloth is, for example, 2 to 10.

The formed substrate 121 has a thickness of 0.3 mm to 0.6 mm, a density of 1.5 g/cm³ to 2.3 g/cm³, transparency of 60% to 90%, a haze of 5% to 20%, a bending strength of 300 MPa to 500 MPa, and a bending modulus of 18 GPa to 30 GPa.

It should be noted that neither thicker or thinner glass fiber cloth means the better. The thicker glass fiber cloth may affect its transparency. Excessively thin glass fiber cloth presents insufficient tension, and is vulnerable to being torn during rolling.

In addition, the quantity of layers of stacked glass fiber cloth should not be excessively large. More layers indicate a thicker plate and lower transparency.

Furthermore, soaking time of the glass fiber cloth may be further controlled, so that an impregnation amount of the glass fiber cloth is adjustable.

During forming of the substrate, the glass fiber epoxy resin is further formed through hot-pressing after being soaked, so that a microstructure of the transparent glass fiber plate and a distribution form, a size, a structure, and a quantity of particles can be improved through hot-pressing, and a crystal structure is uniform, thereby improving a strength and good light transmittance of the transparent glass fiber plate material.

Therefore, as the substrate 121, the glass fiber epoxy resin composite plate is high in transparency, and the decoration layers may be disposed on both sides.

The first decoration layer 122 is disposed on the first surface of the substrate 121, and the second decoration layer 123 is disposed on the second surface of the substrate 121.

As shown in FIG. 5, FIG. 6, and FIG. 7, the first decoration layer 122 includes a reflection layer 1223 and at least one of a color layer 1221 and a texture layer 1222 that are stacked. The color layer 1221 and the texture layer 1222 are close to the substrate 121, and the reflection layer 1223 is far away from the substrate 121.

In some embodiments of this application, as shown in FIG. 5, the first decoration layer 122 includes the color layer 1221 and the reflection layer 1223.

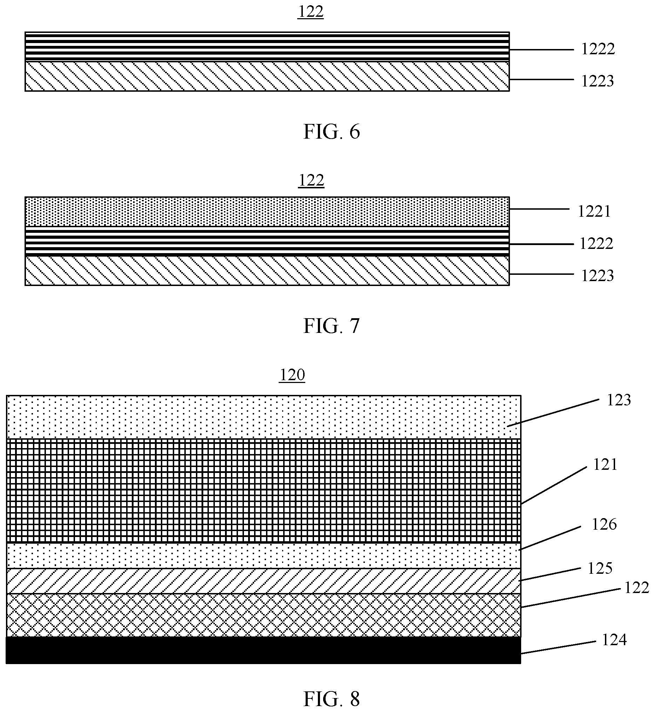

In some other embodiments of this application, as shown in FIG. 6, the first decoration layer 122 includes the texture layer 1222 and the reflection layer 1223.

In another embodiment of this application, as shown in FIG. 7, the first decoration layer 122 includes the color layer 1221, the texture layer 1222, and the reflection layer 1223.

The following uses an example in which the first decoration layer 122 includes the color layer 1221, the texture layer 1222, and the reflection layer 1223 for description.

The color layer 1221 may be first formed on the first surface of the substrate 121, and then the texture layer 1222 is formed on a surface that is of the color layer 1221 and that is away from the substrate 121.

The color layer 1221 may be formed by providing ink on the first surface of the substrate 121. A manner of providing the ink includes printing, printing out, spraying, silkscreen printing, dip dyeing, or the like.

A material and a thickness of the color layer 1221 are not limited in embodiments of this application. For example, the color layer 1221 includes at least one layer of monochromatic ink, for example, red, green, or blue. When the color layer 1221 includes a plurality of layers of monochromatic ink of different colors, a color gradient effect may be further implemented. Therefore, the color layer 1221 can enrich a color effect of the product.

The thickness of the color layer 1221 is, for example, 5 µm to 10 µm.

The texture layer 1222 may be formed by transferring a UV adhesive on a surface that is of the color layer 1221 and that faces away from the substrate 121 in an ultraviolet (Ultraviolet, UV) transferring manner.

A UV transfer adhesive may be first disposed on the surface that is of the color layer 1221 and that faces away from the substrate 121, then texture is given to the UV transfer adhesive by using a mold, and then the UV transfer adhesive is cured and formed through ultraviolet irradiation.

A material and a thickness of the texture layer 1222 are not limited in embodiments of this application. The material of the texture layer 1222 may include one or more of epoxy acrylate, polyurethane acrylate, polyether acrylate, polyester acrylate, and acrylic resin.

For example, the thickness of the texture layer 1222 is 5 µm to 20 µm.

Based on the formed texture layer 1222, a finally prepared product may reflect light differently, so that the product has special texture in appearance, and a product appearance use effect is enriched.

It may be understood that, in another embodiment of this application, the texture layer 1222 may be first formed on the first surface of the substrate 121, and then the color layer 1221 is formed based on the texture layer 1222.

The reflection layer 1223 may be electroplated on a surface that is of the color layer 1221 or the texture layer 1222 and that is away from the substrate 121. The reflection layer 1223 is configured to reflect light transmitted by the second surface of the substrate 121, so that the color layer 1221 and the texture layer 1222 can reflect a good appearance decoration effect.

A material and a thickness of the reflection layer 1223 are not limited in embodiments of this application. For example, the material of the reflection layer 1223 includes one or more of an indium tin alloy film layer, a silicon dioxide film layer, a titanium oxide film layer, and a zirconia film layer.

The thickness of the reflection layer 1223 is 0.05 µm to 1.0 µm.

In addition, as shown in FIG. 4, the housing assembly 120 further includes a light shielding layer 124. The light shielding layer 124 is disposed on a surface that is of the first decoration layer 122 and that is away from the substrate 121.

The light shielding layer 124 may be obtained by forming an ink layer on the surface that is of the first decoration layer 122 and that is away from the substrate 121. A forming manner of the ink layer includes: printing, printing out, spraying, silkscreen printing, dip dyeing, or the like.

A material and a thickness of the light shielding layer 124 are not limited in embodiments of this application. The light shielding layer 124 includes at least one layer of monochromatic ink. A color can be black or white to prevent light penetration and light leakage. For example, the material of the light shielding layer 124 includes one or more of epoxy resin, acrylate resin, and polyurethane resin.

For example, the thickness of the light shielding layer 124 is 5 µm to 20 µm.

It should be noted that, in some embodiments of this application, the color layer 1221 may also be used as the light shielding layer 124, and a light shielding structure such as another light shielding layer does not need to be disposed. In this case, the color layer 1221 may be disposed on a side that is of the first decoration layer 122 and that is away from the substrate 121.

A manner of connecting the first decoration layer 122 to the substrate 121 is not limited in embodiments of this application. In some embodiments of this application, as shown in FIG. 4, the first decoration layer 122 is directly formed on the first surface of the substrate 121.

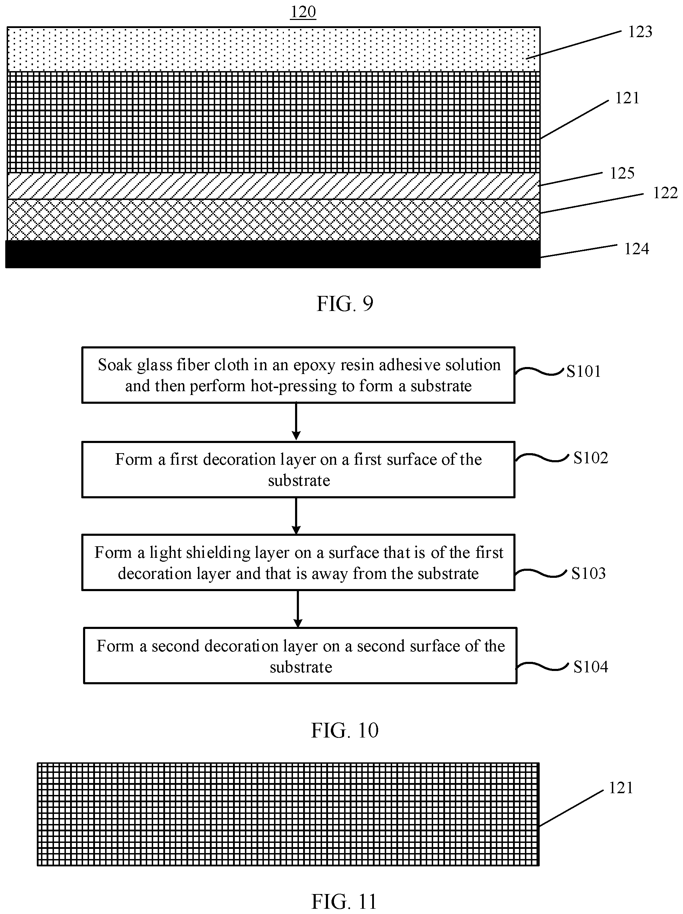

In some other embodiments of this application, as shown in FIG. 8 and FIG. 9, the housing assembly further includes a membrane 125. The membrane 125 is disposed close to the first surface of the substrate 121, and the first decoration layer 122 is disposed on the membrane 125.

A material and a thickness of the membrane 125 are not limited in embodiments of this application. For example, the material of the membrane 125 includes one or more of a polyethylene terephthalate (Polyethylene terephthalate, PET) plate, a polymethyl methacrylate (Polymethyl Methacrylate, PMMA) plate, and a polycarbonate (Polycarbonate, PC) plate.

It should be noted that the PET plate has excellent electrical insulation performance, creep resistance performance, and fatigue resistance performance.

The PMMA plate, commonly known as plexiglass, is the most excellent texture in synthetic transparent materials, and is more suitable in price; and is not easy to produce sharp fragments when broken, and has a better appearance and easy to process.

The PC plate is tough thermoplastic resin, has colorless transparency, heat resistance, impact resistance, and other characteristics, and has good mechanical properties.

For example, the thickness of the membrane 125 is 0.1 mm to 0.2 mm. For example, the thickness of the membrane 125 is 0.115 mm or 0.125 mm.

A manner of connecting the membrane 125 to the substrate 121 is not limited in embodiments of this application. In some embodiments, as shown in FIG. 8, the membrane 125 is bonded to the first surface of the substrate 121 by using a transparent adhesive layer 126.

The transparent adhesive layer 126 is, for example, located on a side that is of the membrane 125 and that is close to the substrate 121, and the transparent adhesive layer 126 may be bonded to the substrate 121 through heating and pressing.

A material and a thickness of the transparent adhesive layer 126 are not limited in embodiments of this application, and the transparent adhesive layer 126 is, for example, an optically clear adhesive (Optically Clear Adhesive, OCA). For example, the material of the transparent adhesive layer 126 includes one or more of an acrylic adhesive, unsaturated polyester, polyurethane, and an epoxy adhesive.

For example, the thickness of the transparent adhesive layer 126 is 10 µm to 50 µm.

In some other embodiments, as shown in FIG. 9, the membrane 125 and the substrate 121 are integrally formed.

The substrate 121 may be formed through hot-pressing after the glass fiber cloth is soaked in the epoxy resin adhesive solution. After the glass fiber cloth is soaked in the epoxy resin adhesive solution, the membrane 125 may be attached to the glass fiber cloth, and then the soaked glass fiber cloth and the membrane 125 are integrally formed through hot-pressing. In this way, the substrate 121 and the membrane 125 are more securely connected.

In addition, still refer to FIG. 4, FIG. 8, and FIG. 9. The second decoration layer 123 is disposed on the second surface of the substrate 121.

The second decoration layer 123 includes a hardening layer, and a surface of the hardening layer is a frosted surface.

The hardening layer may be formed by coating hardening liquid on the second surface of the substrate 121 and performing UV curing. It should be noted that the UV curing means that the hardening liquid is formed through curing after being cured and crosslinked through ultraviolet irradiation.

When the second decoration layer 123 is formed, the hardening liquid may be first coated on the second surface of the substrate 121, to form the hardening layer through UV curing, then mold rubbing is performed on a surface of the semi-cured hardening layer, to form a frosted surface, and then the hardening layer continues to be cured in the UV curing manner, to form a surface having a glitter sand effect.

A material and a thickness of the hardening layer are not limited in embodiments of this application. For example, the material of the hardening layer includes acrylate. For example, the thickness of the hardening layer is 5 µm to 20 µm.

In some embodiments of this application, a first glossy coating (not shown in the figure) is further disposed on the first surface of the substrate 121, and the first glossy coating is located between the first surface of the substrate 121 and the first decoration layer 122.

In this way, the first decoration layer 122 can better attach to the surface of the substrate 121.

In some embodiments of this application, a second glossy coating (not shown in the figure) is further disposed on the second surface of the substrate 121, and the second glossy coating is located between the second surface of the substrate 121 and the second decoration layer 123.

In this way, the second decoration layer 123 can better attach to the surface of the substrate 121.

Materials and thicknesses of the first glossy coating and the second glossy coating are not limited in embodiment of this application. For example, materials of the first glossy coating and the second glossy coating include acrylic resin and polyurethane resin.

For example, the thicknesses of the first glossy coating and the second glossy coating are 5 µm to 15 µm.

The following describes a structure and a preparation method of the housing assembly with reference to an example 1, an example 2, and an example 3.

### Example 1

This example provides a housing assembly. As shown in FIG. 4, the housing assembly includes a second decoration layer 123, a substrate 121, a first decoration layer 122, and a light shielding layer 124 that are stacked.

FIG. 10 is a housing assembly preparation method according to the example 1. As shown in FIG. 10, the preparation method includes the following steps.

S101: As shown in FIG. 11, soak glass fiber cloth in an epoxy resin adhesive solution and then perform hot-pressing to form the substrate 121.

The substrate 121 includes a glass fiber epoxy resin composite plate. The glass fiber epoxy resin composite plate is high in strength and modulus. The glass fiber epoxy resin composite plate is used for the battery cover, which is a light and thin material, and is high in strength.

A thickness, a quantity of layers, and a combination form of the glass fiber cloth are not limited in embodiments of this application. For example, a thickness of single-layer glass fiber cloth may be 0.03 mm to 0.2 mm, and a thickness of each stacked layer and a quantity of stacked layers are not limited. A thickness of a high-transparency glass fiber plate formed through stacking and hot-pressing is 0.3 mm to 0.6 mm.

Preferably, the thickness of the glass fiber cloth is 0.05 mm or 0.1 mm.

A quantity of layers of stacked glass fiber cloth is, for example, 2 to 10.

The formed substrate 121 has a thickness of 0.3 mm to 0.6 mm, a density of 1.5 g/cm³ to 2.3 g/cm³, transparency of 60% to 90%, a haze of 5% to 20%, a bending strength of 300 MPa to 500 MPa, and a bending modulus of 18 GPa to 30 GPa.

It should be noted that neither thicker or thinner glass fiber cloth means the better. The thicker glass fiber cloth may affect its transparency. Excessively thin glass fiber cloth presents insufficient tension, and is vulnerable to being torn during rolling.

In addition, the quantity of layers of stacked glass fiber cloth should not be excessively large. More layers indicate a thicker plate and lower transparency.

Furthermore, soaking time of the glass fiber cloth may be further controlled, so that an impregnation amount of the glass fiber cloth is adjustable.

During forming of the substrate, the glass fiber epoxy resin is further formed through hot-pressing after being soaked, so that a microstructure of the transparent glass fiber plate and a distribution form, a size, a structure, and a quantity of particles can be improved through hot-pressing, and a crystal structure is uniform, thereby improving a strength and good light transmittance of the transparent glass fiber plate material.

Therefore, as the substrate 121, the glass fiber epoxy resin composite plate is high in transparency, and the decoration layers may be disposed on both sides.

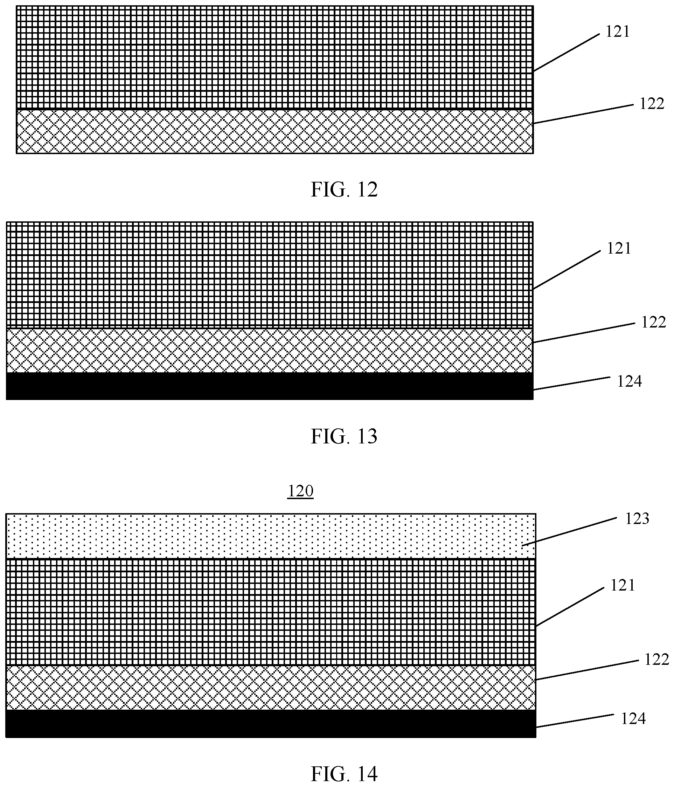

S102: As shown in FIG. 12, form the first decoration layer 122 on a first surface of the substrate 121.

The substrate 121 includes the first surface and a second surface that are disposed opposite to each other, and the first surface of the substrate 121 is disposed close to an electronic device.

The first decoration layer 122 includes a reflection layer 1223 and at least one of a color layer 1221 and a texture layer 1222 that are stacked. The color layer 1221 and the texture layer 1222 are close to the substrate 121, and the reflection layer 1223 is away from the substrate 121.

In some embodiments of this application, the first decoration layer 122 includes the color layer 1221 and the reflection layer 1223.

In some other embodiments of this application, the first decoration layer 122 includes the texture layer 1222 and the reflection layer 1223.

In another embodiment of this application, the first decoration layer 122 includes the color layer 1221, the texture layer 1222, and the reflection layer 1223.

The following uses an example in which the first decoration layer 122 includes the color layer 1221, the texture layer 1222, and the reflection layer 1223 for description.

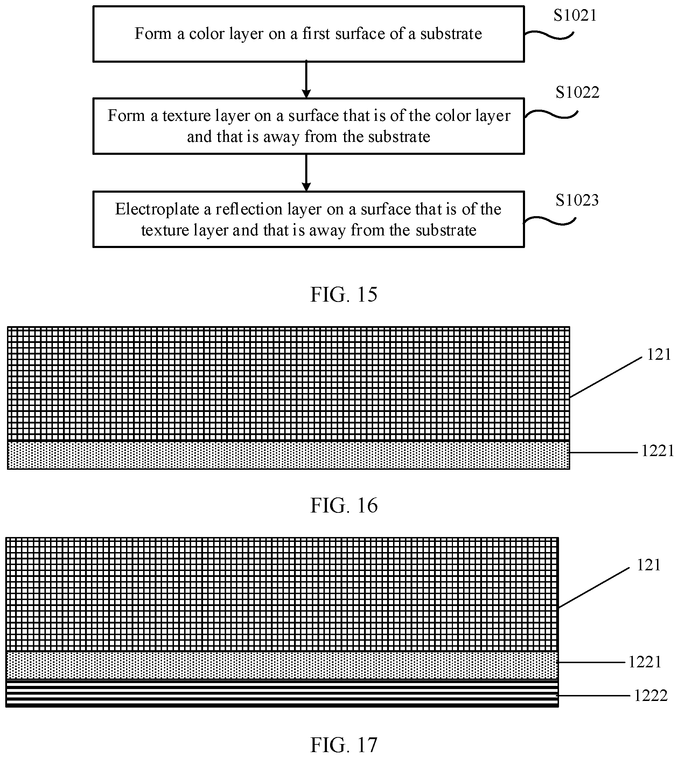

In some embodiments of this application, the first decoration layer 122 is directly formed on the first surface of the substrate 121. As shown in FIG. 15, a method for forming the first decoration layer 122 on the first surface of the substrate 121 in S102 includes the following steps.

S1021: As shown in FIG. 16, form the color layer 1221 on the first surface of the substrate 121.

The color layer 1221 may be formed by providing ink on the first surface of the substrate 121. A manner of providing the ink includes printing, printing out, spraying, silkscreen printing, dip dyeing, or the like.

A material and a thickness of the color layer 1221 are not limited in embodiments of this application. For example, the color layer 1221 includes at least one layer of monochromatic ink, for example, red, green, or blue. When the color layer 1221 includes a plurality of layers of monochromatic ink of different colors, a color gradient effect may be further implemented. Therefore, the color layer 1221 can enrich a color effect of the product.

The thickness of the color layer 1221 is, for example, 5 µm to 10 µm.

S1022: As shown in FIG. 17, form the texture layer 1222 on a surface that is of the color layer 1221 and that is away from the substrate 121.

The texture layer 1222 may be formed by transferring a UV adhesive on a surface that is of the color layer 1221 and that faces away from the substrate 121 in a UV transferring manner.

A UV transfer adhesive may be first disposed on the surface that is of the color layer 1221 and that faces away from the substrate 121, then texture is given to the UV transfer adhesive by using a mold, and then the UV transfer adhesive is cured and formed through ultraviolet irradiation.

A material and a thickness of the texture layer 1222 are not limited in embodiments of this application. The material of the texture layer 1222 includes one or more of epoxy acrylate, urethane acrylate, polyether acrylate, polyester acrylate, and acrylic resin.

The thickness of the texture layer 1222 is 5 µm to 20 µm.

Based on the formed texture layer 1222, a finally prepared product may reflect light differently, so that the product has special texture in appearance, and a product appearance use effect is enriched.

It may be understood that, in another embodiment of this application, the texture layer 1222 may be first formed on the first surface of the substrate 121, and then the color layer 1221 is formed based on the texture layer 1222.

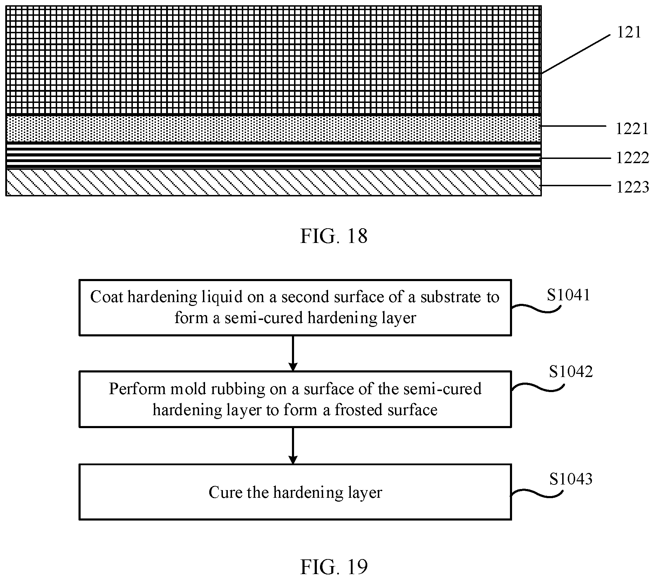

S1023: As shown in FIG. 18, electroplate the reflection layer 1223 on a surface that is of the texture layer 1222 and that is away from the substrate.

The reflection layer 1223 may be electroplated on the texture layer 1222 in a vacuum electroplating manner. The reflection layer 1223 is configured to reflect light transmitted by the second surface of the substrate 121, so that the color layer 1221 and the texture layer 1222 can reflect a good appearance decoration effect.

A material and a thickness of the reflection layer 1223 are not limited in embodiments of this application. For example, the material of the reflection layer 1223 includes one or more of an indium tin alloy film layer, a silicon dioxide film layer, a titanium oxide film layer, and a zirconia film layer.

The thickness of the reflection layer 1223 is 0.05 µm to 1.0 µm.

S103: As shown in FIG. 13, form the light shielding layer 124 on a surface that is of the first decoration layer 122 and that is away from the substrate.

The light shielding layer 124 may be formed by providing ink on the surface that is of the first decoration layer 122 and that is away from the substrate 121. A manner of providing the ink includes printing, printing out, spraying, silkscreen printing, dip dyeing, or the like.

A material and a thickness of the light shielding layer 124 are not limited in embodiments of this application. The light shielding layer 124 includes at least one layer of monochromatic ink. A color can be black or white to prevent light penetration and light leakage. For example, the material of the light shielding layer 124 includes one or more of epoxy resin, acrylate resin, and polyurethane resin.

For example, the thickness of the light shielding layer 124 is 5 µm to 20 µm.

S104: As shown in FIG. 14, form the second decoration layer 123 on the second surface of the substrate 121.

The second decoration layer 123 is disposed on the second surface of the substrate 121.

The second decoration layer 123 includes a hardening layer, and a surface of the hardening layer is a frosted surface.

The hardening layer may be formed by coating hardening liquid on the second surface of the substrate 121 and performing UV curing.

As shown in FIG. 19, the forming the second decoration layer 123 on the second surface of the substrate 121 includes the following steps.

S1041: Coat the hardening liquid on the second surface of the substrate 121 to form the semi-cured hardening layer.

A material and a thickness of the hardening layer are not limited in embodiments of this application. For example, the material of the hardening layer includes acrylate. For example, the thickness of the hardening layer is 5 µm to 20 µm.

The hardening liquid may be cured in a UV curing manner.

It should be noted that the UV curing means that the hardening liquid is formed through hardening after being cured and crosslinked through ultraviolet irradiation.

S1042: Perform mold rubbing on a surface of the semi-cured hardening layer to form a frosted surface.

After the frosted surface is cured, a surface having a glitter sand effect may be formed.

S1043: Cure the hardening layer.

The hardening layer may be further cured in a UV curing manner.

According to the housing assembly provided in this example, the first decoration layer is directly formed on the substrate, and a process is simpler.

### Example 2

This example provides a housing assembly. As shown in FIG. 8, the housing assembly includes a second decoration layer 123, a substrate 121, a transparent adhesive layer 126, a membrane 125, a first decoration layer 122, and a light shielding layer 124 that are stacked.

For forming manners of the second decoration layer 123, the substrate 121, the first decoration layer 122, and the light shielding layer 124, refer to the example 1. Details are not described herein again.

The housing assembly further includes the membrane 125. The membrane 125 is disposed close to a first surface of the substrate 121, and the first decoration layer 122 is disposed on the membrane 125. A manner of connecting the membrane 125 to the substrate 121 is not limited in embodiments of this application. In some embodiments, the membrane 125 is bonded to the first surface of the substrate 121 by using the transparent adhesive layer 126. In some other embodiments, the membrane 125 and the substrate 121 are integrally formed through hot-pressing.

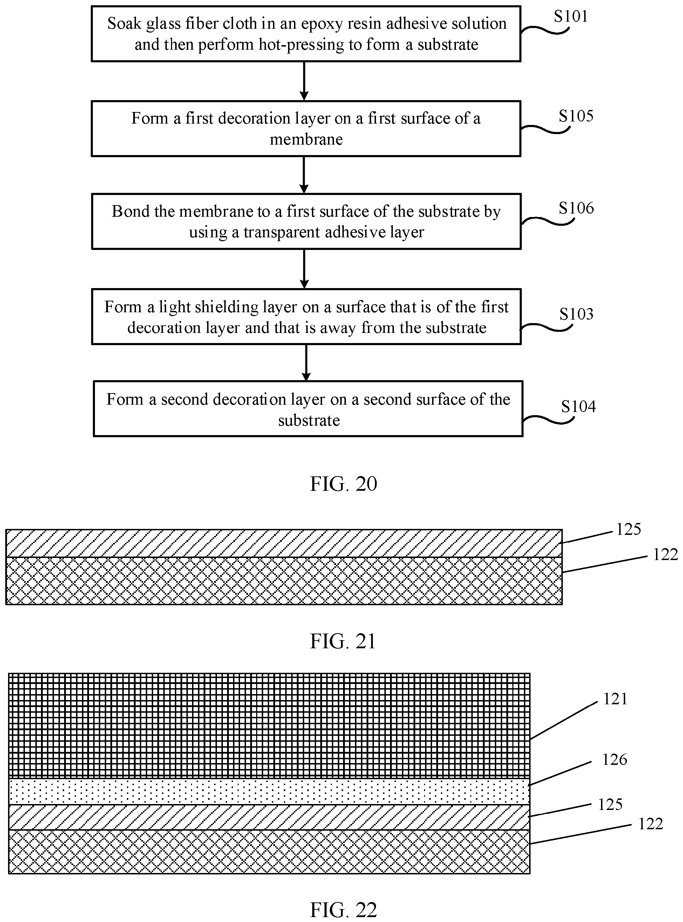

FIG. 20 is a flowchart of a housing assembly preparation method according to the example 2. In this example, when the membrane 125 is bonded to the first surface of the substrate 121 by using the transparent adhesive layer 126, as shown in FIG. 20, in the housing assembly preparation method, compared with the example 1, in step S102 of forming the first decoration layer on a first surface of the substrate, the method may be replaced with the following.

S105: As shown in FIG. 21, form the first decoration layer 122 on a first surface of the membrane 125.

The membrane 125 includes a first surface and a second surface that are opposite to each other, the second surface of the membrane 125 is close to the substrate 121, and the first surface of the membrane 125 is away from the substrate 121.

A material and a thickness of the membrane 125 are not limited in embodiments of this application. For example, the material of the membrane 125 includes one or more of a polyethylene terephthalate (Polyethylene terephthalate, PET) plate, a polymethyl methacrylate (Polymethyl Methacrylate, PMMA) plate, and a polycarbonate (Polycarbonate, PC) plate.

It should be noted that the PET plate has excellent electrical insulation performance, creep resistance performance, and fatigue resistance performance.

The PMMA plate, commonly known as plexiglass, is the most excellent texture in synthetic transparent materials, and is more suitable in price; and is not easy to produce sharp fragments when broken, and has a better appearance and easy to process.

The PC plate is tough thermoplastic resin, has colorless transparency, heat resistance, impact resistance, and other characteristics, and has good mechanical properties.

The thickness of the membrane 125 is 0.1 mm to 0.2 mm. For example, the thickness of the membrane 125 is 0.115 mm or 0.125 mm.

S106: As shown in FIG. 22, bond the membrane 125 to the first surface of the substrate 121 by using the transparent adhesive layer 126.

The second surface of the membrane 125 is opposite to the first surface of the substrate 121.

The transparent adhesive layer 126 is, for example, located on a side that is of the membrane 125 and that is close to the substrate 121, and the transparent adhesive layer 126 may be bonded to the substrate 121 through heating and pressing.

A material and a thickness of the transparent adhesive layer 126 are not limited in embodiments of this application, and the transparent adhesive layer 126 is, for example, an optically clear adhesive (Optically Clear Adhesive, OCA). For example, the material of the transparent adhesive layer 126 includes one or more of an acrylic adhesive, unsaturated polyester, polyurethane, and an epoxy adhesive.

For example, the thickness of the transparent adhesive layer 126 is 10 µm to 50 µm.

Therefore, the membrane is bonded to the substrate by using the transparent adhesive layer, no hot-pressing is required, and a process is simple.

It should be noted that a structure of the first decoration layer 122 is not limited in embodiments of this application. In some embodiments, the first decoration layer 122 includes a reflection layer 1223 and at least one of a color layer 1221 and a texture layer 1222 that are stacked. The color layer 1221 and the texture layer 1222 are close to the substrate 121, and the reflection layer 1223 is away from the substrate 121.

In some embodiments of this application, the first decoration layer 122 includes the color layer 1221 and the reflection layer 1223.

In some other embodiments of this application, the first decoration layer 122 includes the texture layer 1222 and the reflection layer 1223.

In another embodiment of this application, the first decoration layer 122 includes the color layer 1221, the texture layer 1222, and the reflection layer 1223.

The following uses an example in which the first decoration layer 122 includes the color layer 1221, the texture layer 1222, and the reflection layer 1223 for description.

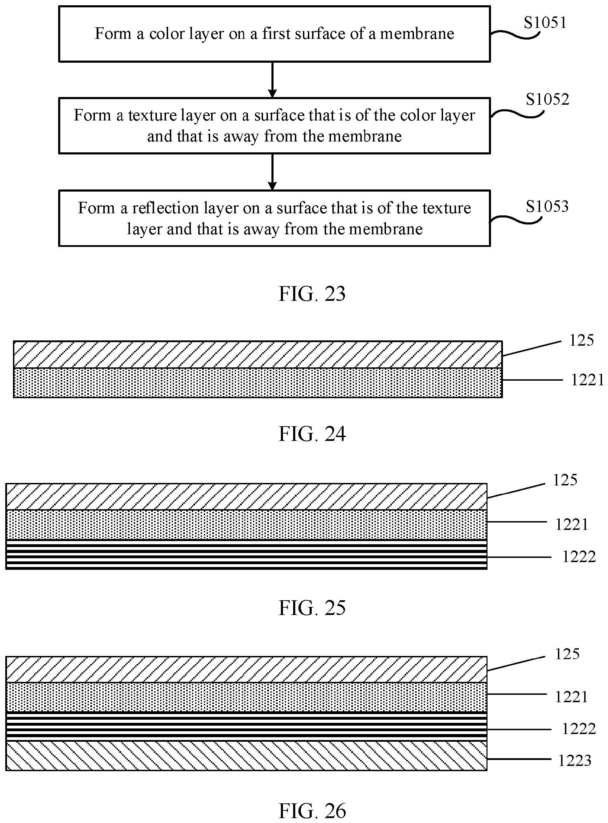

As shown in FIG. 23, the forming the first decoration layer 122 on a first surface of the membrane 125 includes the following steps.

S1051: As shown in FIG. 24, form the color layer 1221 on the first surface of the membrane 125.

The color layer 1221 may be formed by providing ink on the first surface of the membrane 125. A manner of providing the ink includes printing, printing out, spraying, silkscreen printing, dip dyeing, or the like.

For a structure of the color layer 1221, refer to the foregoing embodiment. Details are not described herein again.

S1052: As shown in FIG. 25, form the texture layer 1222 on a surface that is of the color layer 1221 and that is away from the membrane 125.

The texture layer 1222 may be formed by transferring a UV adhesive on a surface that is of the color layer 1221 and that faces away from the substrate 121 in a UV transferring manner.

A UV transfer adhesive may be first disposed on the surface that is of the color layer 1221 and that faces away from the substrate 121, then texture is given to the UV transfer adhesive by using a mold, and then the UV transfer adhesive is cured and formed through ultraviolet irradiation.

Based on the formed texture layer 1222, a finally prepared product may reflect light differently, so that the product has special texture in appearance, and a product appearance use effect is enriched.

For a structure of the texture layer 1222, refer to the foregoing embodiment. Details are not described herein again.

It may be understood that, in another embodiment of this application, the texture layer 1222 may be first formed on the first surface of the membrane 125, and then the color layer 1221 is formed based on the texture layer 1222.

S1053: As shown in FIG. 26, electroplate the reflection layer 1223 on a surface that is of the texture layer 1222 and that is away from the membrane 125.

The reflection layer 1223 is configured to reflect light transmitted by a second surface of the substrate 121, so that the color layer 1221 and the texture layer 1222 can reflect a good appearance decoration effect.

For a structure of the reflection layer 1223, refer to the foregoing embodiment. Details are not described herein again.

According to the housing assembly provided in this example, the membrane is bonded to the substrate by using the transparent adhesive layer, no hot-pressing is required, and a process is simple.

### Example 3

This example provides a housing assembly. As shown in FIG. 9, the housing assembly includes a second decoration layer 123, a substrate 121, a membrane 125, a first decoration layer 122, and a light shielding layer 124 that are stacked.

For forming manners of the second decoration layer 123, the substrate 121, the first decoration layer 122, and the light shielding layer 124, refer to the example 1. Details are not described herein again.

In this example, the membrane 125 and the substrate 121 are integrally formed through hot-pressing.

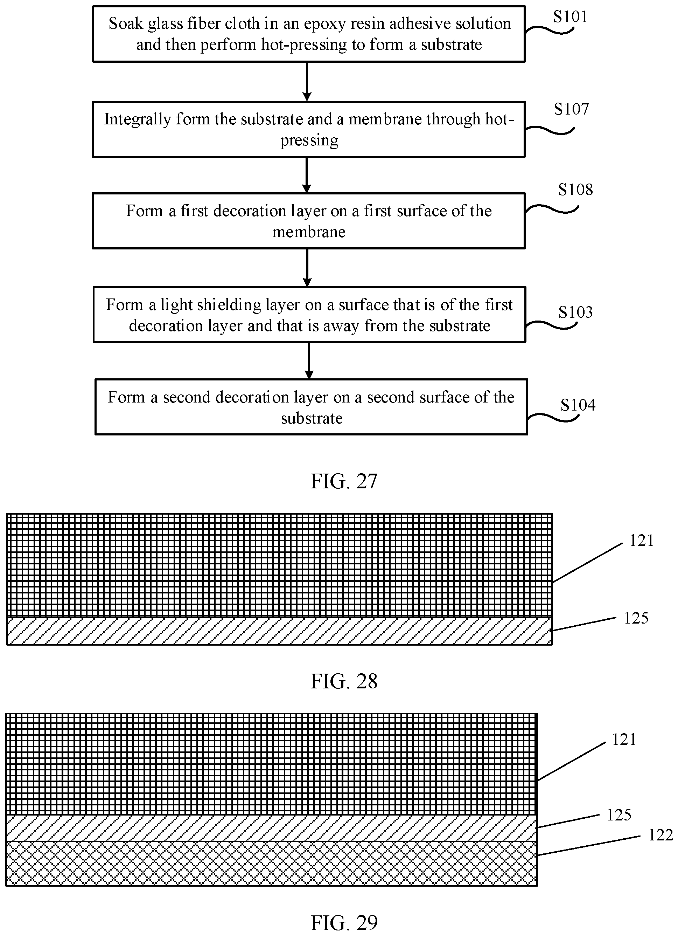

FIG. 27 is a flowchart of a housing assembly preparation method according to the example 3. In this example, the membrane 125 and the substrate 121 are integrally formed through hot-pressing. As shown in FIG. 27, in the housing assembly preparation method, compared with the example 1, step S102 of forming the first decoration layer on a first surface of the substrate may be replaced with the following.

S107: As shown in FIG. 28, integrally form the substrate 121 and the membrane 125 through hot-pressing.

The substrate 121 may be formed through hot-pressing after glass fiber cloth is soaked in an epoxy resin adhesive solution. After the glass fiber cloth is soaked in the epoxy resin adhesive solution, the membrane 125 may be attached to the glass fiber cloth, and then the soaked glass fiber cloth and the membrane 125 are integrally formed through hot-pressing. In this way, the substrate 121 and the membrane 125 are more securely connected.

S108: As shown in FIG. 29, form the first decoration layer 122 on a first surface of the membrane 125.

A thickness of the membrane 125 is 0.1 mm to 0.2 mm. For example, the thickness of the membrane 125 is 0.115 mm or 0.125 mm.

The membrane 125 includes the first surface and a second surface that are opposite to each other, the second surface of the membrane 125 is close to the substrate 121, and the first surface of the membrane 125 is away from the substrate 121.

For a step of forming the first decoration layer 122 on the first surface of the membrane 125, refer to FIG. 22. Details are not described herein again.

Therefore, the membrane and the substrate are directly formed through hot-pressing, and the connection is more stable.

### Example 4

This example provides a housing assembly. The housing assembly includes a second decoration layer 123, a substrate 121, a first glossy coating, a first decoration layer 122, and a light shielding layer 124 that are stacked.

For forming manners of the second decoration layer 123, the substrate 121, the first decoration layer 122, and the light shielding layer 124, refer to the example 1. Details are not described herein again.

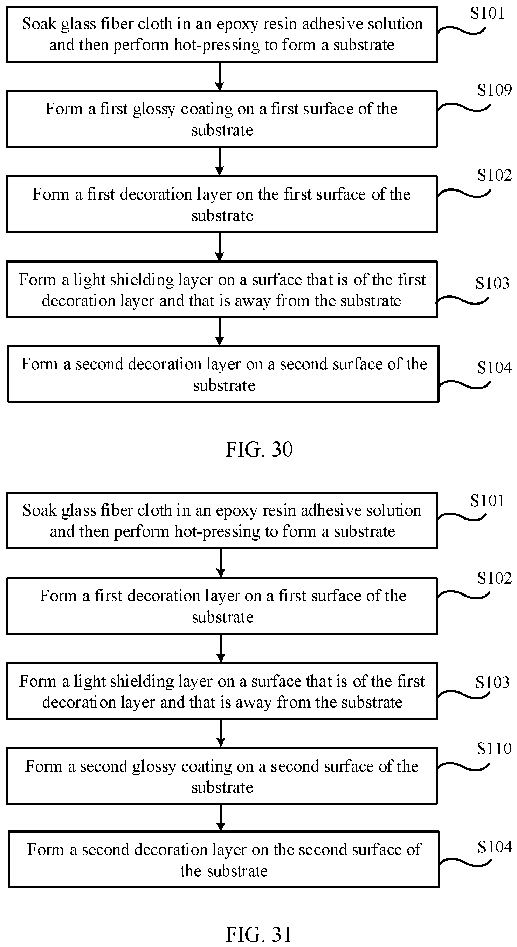

FIG. 30 is a flowchart of a housing assembly preparation method according to the example 4. As shown in FIG. 30, before step S102, the housing assembly preparation method further includes the following step.

S109: Dispose the first glossy coating on a first surface of the substrate 121.

The first glossy coating is located between the first surface of the substrate 121 and the first decoration layer 122.

In this way, the first decoration layer 122 can better attach to the surface of the substrate 121.

A material of the first glossy coating includes, for example, acrylic resin and polyurethane resin.

For example, a thickness of the first glossy coating is 5 µm to 15 µm.

Therefore, the first glossy coating can better attach the first decoration layer to the surface of the substrate.

It should be noted that, in this example, the first glossy coating is disposed on the first surface of the substrate 121 based on the example 1. In some other embodiments of this example, the first glossy coating may also be disposed on the first surface of the substrate 121 based on the example 2 and the example 3. These all fall within the protection scope of this application.

### Example 5

This example provides a housing assembly. The housing assembly includes a second decoration layer 123, a second glossy coating, a substrate 121, a first decoration layer 122, and a light shielding layer 124 that are stacked.

For forming manners of the second decoration layer 123, the substrate 121, the first decoration layer 122, and the light shielding layer 124, refer to the example 1. Details are not described herein again.

FIG. 31 is a flowchart of a housing assembly preparation method according to the example 5. As shown in FIG. 31, before step S104, the housing assembly preparation method further includes the following step.

S110: Dispose the second glossy coating on a second surface of the substrate 121.

The second glossy coating is located between the second surface of the substrate 121 and the second decoration layer 123, so that the second decoration layer 123 can better attach to the surface of the substrate 121.

A material of the second glossy coating includes, for example, acrylic resin and polyurethane resin.

For example, a thickness of the second glossy coating is 5 µm to 15 µm.

Therefore, the second glossy coating can better attach the second decoration layer to the surface of the substrate.

It should be noted that, in this example, the second glossy coating is disposed on the second surface of the substrate 121 based on the example 1. In some other embodiments of this example, the second glossy coating may also be disposed on the second surface of the substrate 121 based on the example 2, the example 3, and the example 4. These all fall within the protection scope of this application.

According to the housing assembly, the housing assembly preparation method, and the electronic device provided in this application, the substrate of the housing assembly formed through hot-pressing after the glass fiber cloth is soaked in the epoxy resin adhesive solution, so that the substrate is high in transparency, and decoration layers can be formed on two surfaces of the substrate, thereby implementing application of a solution of inner texture and an outer glitter effect on the battery cover, and therefore the decoration effect is better, and the battery cover features a light and high-strength characteristic.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A housing assembly, comprising:
a substrate, wherein the substrate comprises a first surface and a second surface that are opposite to each other, the first surface of the substrate is close to an electronic device, and the substrate is formed through hot-pressing after glass fiber cloth is soaked in an epoxy resin adhesive solution;
a first decoration layer, disposed on the first surface of the substrate;
a light shielding layer, disposed on a surface that is of the first decoration layer and that is away from the substrate; and
a second decoration layer, disposed on the second surface of the substrate.

2. The housing assembly according to claim 1, wherein the first decoration layer comprises a reflection layer and at least one of a color layer and a texture layer that are stacked, wherein the color layer and the texture layer are close to the substrate, and the reflection layer is away from the substrate.

3. The housing assembly according to claim 1 or 2, wherein the housing assembly further comprises a membrane, the first decoration layer is disposed on the membrane, and the membrane is bonded to the first surface of the substrate by using a transparent adhesive layer.

4. The housing assembly according to claim 1 or 2, wherein the housing assembly further comprises a membrane, the membrane is located on the first surface of the substrate, the membrane and the substrate are integrally formed through hot-pressing, and the first decoration layer is disposed on the membrane.

5. The housing assembly according to any one of claims 1 to 4, wherein the second decoration layer comprises a hardening layer, and a surface of the hardening layer is a frosted surface.

6. The housing assembly according to any one of claims 1 to 5, wherein a first glossy coating is disposed between the first surface of the substrate and the first decoration layer.

7. The housing assembly according to any one of claims 1 to 6, wherein a second glossy coating is disposed between the second surface of the substrate and the second decoration layer.

8. A housing assembly preparation method, comprising:
soaking glass fiber cloth in an epoxy resin adhesive solution and then performing hot-pressing to form a substrate, wherein the substrate comprises a first surface and a second surface that are disposed opposite to each other, and the first surface of the substrate is disposed close to an electronic device;
forming a first decoration layer on the first surface of the substrate;
forming a light shielding layer on a surface that is of the first decoration layer and that is away from the substrate; and
forming a second decoration layer on the second surface of the substrate.

9. The method according to claim 8, wherein the forming a first decoration layer on the first surface of the substrate comprises:
sequentially stacking at least one of a color layer and a texture layer on the first surface of the substrate.

10. The method according to claim 9, wherein after the sequentially stacking at least one of a color layer and a texture layer on the first surface of the substrate, the method further comprises:
electroplating a reflection layer on the color layer or the texture layer.

11. The method according to claim 8, wherein a housing assembly further comprises a membrane, and the forming a first decoration layer on the first surface of the substrate comprises:
forming the first decoration layer on a first surface of the membrane, wherein the membrane comprises the first surface and a second surface that are opposite to each other; and
bonding the membrane to the first surface of the substrate by using a transparent adhesive layer, wherein the second surface of the membrane is opposite to the first surface of the substrate.

12. The method according to claim 8, wherein a housing assembly further comprises a membrane, and the forming a first decoration layer on the first surface of the substrate comprises:
integrally forming the substrate and the membrane through hot-pressing; and
forming the first decoration layer on a first surface of the membrane, wherein the membrane comprises the first surface and a second surface that are opposite to each other.

13. The method according to claim 11 or 12, wherein the forming the first decoration layer on a first surface of the membrane comprises:
sequentially stacking at least one of a color layer and a texture layer on the first surface of the membrane.

14. The method according to claim 13, wherein after the sequentially stacking at least one of a color layer and a texture layer on the first surface of the membrane, the method further comprises:
electroplating a reflection layer on the color layer or the texture layer.

15. The method according to any one of claims 8 to 14, wherein the forming a second decoration layer on the second surface of the substrate comprises:
coating hardening liquid on the second surface of the substrate to form a hardening layer;
performing mold rubbing on a surface of the semi-cured hardening layer to form a frosted surface; and
curing the hardening layer.

16. The method according to any one of claims 8 to 15, wherein before the forming a first decoration layer on the first surface of the substrate, the method further comprises:
printing a first glossy coating on the first surface of the substrate.

17. The method according to any one of claims 8 to 16, wherein before the forming a second decoration layer on the second surface of the substrate, the method further comprises:
printing a first glossy coating on the second surface of the substrate.

18. An electronic device, comprising a middle frame, a display, and a battery cover, wherein the battery cover and the display are respectively connected to two opposite sides of the middle frame, and the battery cover comprises the housing assembly according to any one of claims 1 to 7, or the battery cover comprises the housing assembly obtained by using the preparation method according to any one of claims 8 to 17.
